(19) **Europäisches Patentamt**

**European Patent Office**

**Office européen des brevets**

(11) **EP 1 238 459 B1**

(12) **EUROPÄISCHE PATENTSCHRIFT**

(45) Veröffentlichungstag und Bekanntmachung des Hinweises auf die Patenterteilung:
**04.08.2004 Patentblatt 2004/32**

(51) Int Cl.⁷: **H03H 7/48**

(21) Anmeldenummer: **00976020.8**

(86) Internationale Anmeldenummer:
**PCT/EP2000/011141**

(22) Anmeldetag: **10.11.2000**

(87) Internationale Veröffentlichungsnummer:
**WO 2001/043283 (14.06.2001 Gazette 2001/24)**

(54) **VERSTÄRKERANORDNUNG MIT 90 -LEISTUNGSTEILER**

AMPLIFIER ARRANGEMENT WITH 90 -POWER DIVIDER

CIRCUIT D'AMPLIFICATION AVEC DIVISEUR DE PUISSANCE A 90

(84) Benannte Vertragsstaaten:
**DE FR GB IT SE**

(30) Priorität: **09.12.1999 DE 19959406**

(43) Veröffentlichungstag der Anmeldung:
**11.09.2002 Patentblatt 2002/37**

(73) Patentinhaber: **Rohde & Schwarz GmbH & Co. KG**
**81671 München (DE)**

(72) Erfinder: **BÖGL, Thomas**
**86179 Augsburg (DE)**

(74) Vertreter: **Körfer, Thomas, Dipl.-Phys. et al**
**Mitscherlich & Partner,**
**Patent- und Rechtsanwälte,**
**Sonnenstrasse 33**
**80331 München (DE)**

(56) Entgegenhaltungen:
**EP-A- 0 458 071          DE-A- 1 513 950**
**GB-A- 2 078 038          US-A- 5 412 351**
**US-A- 5 694 093**

- **KURT LEUCHT: "Die elektrischen Grundlagen der Radiotechnik", 1957, FRANZIS-VERLAG, MüNCHEN**
- **A.S.SEDRA, K.C.SMITH: "Microelectronic Circuits", 1991, OXFORD UNIVERSITY PRESS, OXFORD**

**Beschreibung**

Die Erfindung betrifft eine Verstärkeranordnung.

Leistungsteiler für Verstärkeranordnung sind bekannt. Sie werden bisher in Form von Richtkopplern, Hybridkoppler oder ähnlichen Kopplerschaltungen beispielsweise mit Transformatoren realisiert. Diese bekannten Leistungsteiler sind aufwendig und teuer. Leistungsteiler für Verstärkeranordnung, die eine eingangsseitige und ausgangsseitige Phasen-verschiebung hervorrufen, sind z.B. aus EP-A-0458071 allgemein bekannt.

Aus der DE-A-1 513 950 ist eine Schaltungsanordnung zur Bildung von Wechselspannungen mit von der Frequenz unabhängigen gegenseitigen Phasenverschiebungen von 90° bekannt. Diese Schaltungsanordnung verwendet in einem ersten Ausgangszweig eine Kapazität und in einem zweiten Ausgangszweig eine Induktivität, die jeweils durch Abschlußwiderstände abgeschlossen sind, so daß ein RC-Glied bzw. ein RL-Glied entsteht. Es entstehen durch diese Schaltungsanordnung zwei Ausgangssignale, die zueinander um 90° phasenverschoben sind. Eine gleichmäßige Leistungsaufteilung der Signale findet jedoch nicht statt. Eine Einbindung in eine Verstärkeranordnug mit mehreren parallel geschalteten Verstärkern ist an Keine Stelle dieses Dokuments angesprochen.

Es ist Aufgabe der Erfindung, eine Verstärkeranordnung zu schaffen, die sehr einfach und preiswert realisiert werden kann und einen geringen Leistungsverbrauch hat.

Diese Aufgabe wird durch die Merkmale des Anspruchs 1 gelöst.

Ein 90°-Leistungsteiler für eine erfindungsgemäße Verstärkeranordnung kann sehr einfach durch einen Kondensator und eine Spule realisiert werden, er besitzt darüberhinaus noch den Vorteil, daß er sehr hoch aussteuerbar ist, was insbesondere bei seiner Anwendung in Funksendern wichtig ist. Er kann auch genausogut zum phasenrichtigen Summieren eingesetzt werden.

Die Erfindung wird im Folgenden anhand schematischer Zeichnungen an Ausführungsbeispielen näher erläutert.

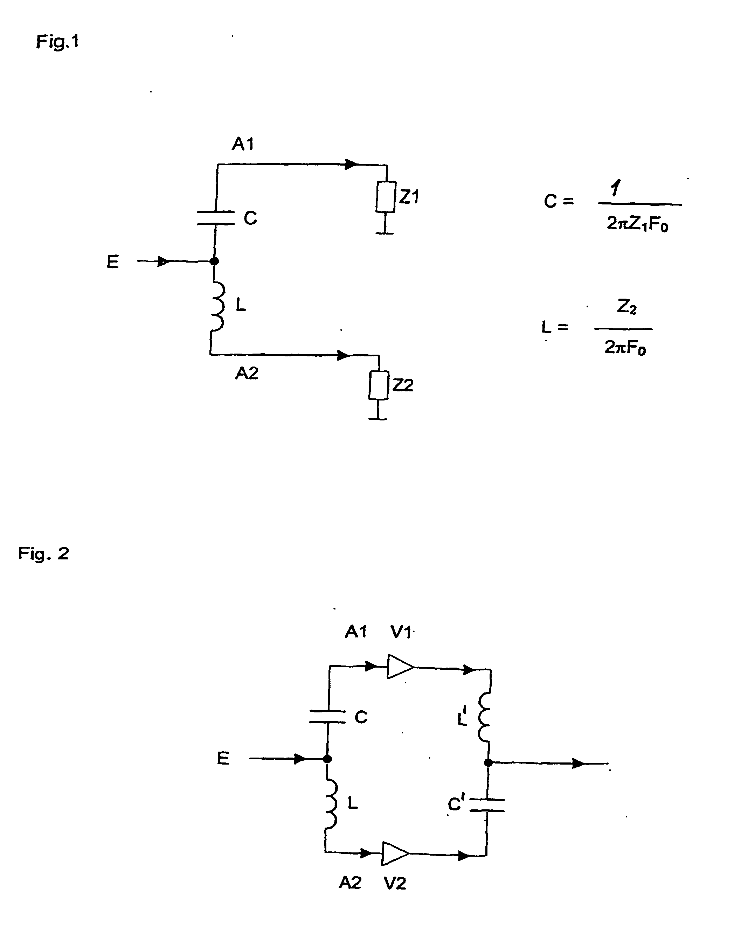

Figur 1 zeigt das Prinzipschaltbild eines erfindungsgemäß eingesetzten 90°-Leistungsteilers bestehend aus einem Kondensator C und einer Induktivität L. Am Eingang E wird ein Eingangssignal zugeführt, das auf die beiden Ausgangszweige A1 und A2 aufgeteilt werden soll, die jeweils mit einer Last Z1 bzw. Z2 abgeschlossen sind. Zur Aufteilung der Leistung des Eingangssignals E zu gleichen Teilen auf die beiden Lasten Z1 und Z2 mit einer gegenseitigen Phasenverschiebung von 90° gilt für die Bemessung des Kondensators C und der Induktivität L folgende Beziehung:

$$C = \frac{1}{2 * \pi * Z1 * Fo}$$

$$L = \frac{Z2}{2 * \pi * Fo}$$

$F_o$ ist dabei die Betriebsfrequenz. Vorteilhafterweise werden die beiden Lastwiderstände Z1 und Z2 gleichgroß gewählt und zwar entsprechend der Systemimpedanz vorzugsweise 50 Ohm. Damit wird erreicht, daß auch am Eingang E Leistungsanpassung herrscht.

Durch die erfindungsgemäße Anordnung wird erreicht, daß der kapazitive Zweig mit +45° voreilend und der induktive Zweig mit -45° nacheilend ist. Daraus ergibt sich eine Differenzphase von 90° zwischen Port 2 und Port 3. Diese Differenzphase wird über einen weiten Frequenzbereich eingehalten. Weicht die Frequenz zu weit von der Mittenfrequenz FO ab, dann wird die Leistung nicht mehr zu gleichen Teilen aufgeteilt. Mit zunehmender Frequenz übernimmt der kapazitive Zweig mit fallender Frequenz der induktive Zweig mehr Leistung. Läßt man als zulässige Leistungsdifferenz zwischen A1 und A2 einen Unterschied von 1dB zu, dann kann die Anordnung über eine Bandbreite von etwa 28 % betrieben werden. Die Beziehung zwischen der Mittenfrequenz und den Frequenzgrenzen lautet wie folgt:

Für Fo gilt:

$$Fo = \sqrt{Fmin * Fmax}$$

Dadurch, daß C und L komplementäre Elemente darstellen, kompensieren sich die Eingangsimpedanzen der beiden Lastzweige in der Weise, daß die Parallelschaltung beider Zweige wieder die Lastimpedanz Z am Eingang erscheinen läßt. Dadurch ist eine gute Anpassung am Eingang sichergestellt.

Dieser 90°-Leistungsteiler eignet sich sehr gut dazu, zwei Verstärkerstufen parallel zu schalten, um die erzielbare Ausgangsleistung zu erhöhen, wie dies Figur 2 zeigt. Dazu wird in jeden der beiden Zweige A1 und A2 nach dem Leistungsteiler L, C je ein Verstärker V1, V2 angeordnet, die Ausgangssignale dieser beiden Verstärker V1 und V2 werden mit einer weiteren aus einer Induktivität L' und einem Kondensator C' bestehenden Schaltung, die dem eingangsseitigen 90°-Leistungsteiler entspricht, zusammengefaßt. Die Induktivität L' und der Kondensator C' auf der Ausgangsseite ist jedoch gespiegelt zu der Anordnung des Leistungsteilers am Eingang aufgebaut, so daß die gewünschte phasenrichtige Summierung am Ausgang erreicht wird. Diese Schaltung zur Leistungserhöhung eignet sich besonders für das Zusammenschalten sogenannter MMICs, da diese üblicherweise intern auf 50 Ohm angepaßt sind und somit gut mit dieser Art von Leistungsteiler zusammenpassen. Berücksichtigt man den Leistungsabfall an den Grenzen der nutzbaren Bandbreite und gewisse Verluste, dann kann mit einer solchen Anordnung eine um 2dB gegenüber einem einzigen Verstärker höhere Aussteuerung erreicht werden.

## Patentansprüche

1. Verstärkeranordnung mit einem 90°-Leistungsteiler zum Aufteilen der Leistung eines Eingangssignals (E) auf zwei um 90° gegeneinander phasenverschobene Ausgangszweige (A1, A2), wobei in einem ersten Ausgangszweig (A1) eine erste Kapazität C und in einem zweiten Ausgangszweig (A2) eine erste Induktivität L angeordnet ist, die wie folgt bemessen sind:

$$C = \frac{1}{2 * \pi * Z1 * Fo}$$

$$L = \frac{Z2}{2 * \pi * Fo}$$

wobei $F_o$ die Mittenfrequenz ist und Z1 und Z2 jeweils die Abschlußwiderstände der Ausgangszweige (A1, A2) sind, wobei in dem ersten Ausgangszweig (A1) in Reihe nach der ersten Kapazität C ein erster Verstärker (V1) und nach dem ersten Verstärker (V1) eine zweite Induktivität (L') angeordnet sind, wobei in dem zweiten Ausgangszweig (A2) in Reihe nach der ersten Induktivität L ein zweiter Verstärker (V2) und nach dem zweiten Verstärker (V2) eine zweite Kapazität (C') angeordnet sind, wobei die zweite Induktivität (L') und die zweite Kapazität (C') an einem Ausgang miteinander verbunden sind.

## Claims

1. Amplifier arrangement with a 90° power divider for distributing the power of an input signal (E) to two output branches (A1, A2) phase-shifted against each other by 90°, wherein in a first output branch (A1) a first capacity C and in a second output branch (A2) a first inductivity L is arranged, with dimensions as follows:

$$C = \frac{1}{2*\pi*Z1*Fo}$$

$$L = \frac{Z2}{2*\pi*Fo}$$

wherein $F_o$ is the centre frequency and Z1 and Z2 are in each case the terminating resistances of the output branches (A1, A2), wherein in the first output branch (A1) in series after the first capacity C a first amplifier (V1) and after the first amplifier (V1) a second inductivity (L') are arranged, wherein in the second output branch (A2) in series after the first inductivity L a second amplifier (V2) and after the second amplifier (V2) a second capacity (C') are arranged, wherein the second inductivity (L') and the second capacity (C') are connected to one another at one output.

## Revendications

1. Agencement amplificateur comprenant un diviseur de puissance à 90° pour la répartition de la puissance d'un signal d'entrée (E) entre deux branches de sortie (A1, A2) déphasées de 90° l'une par rapport à l'autre, un premier condensateur C et une première inductance L étant disposés respectivement dans une première branche de sortie (A1) et dans une seconde branche de sortie (A2), qui sont dimensionnées de la façon suivante:

$$C = \frac{1}{2 * \pi * Z1 * Fo}$$

$$L = \frac{Z2}{2 * \pi * Fo}$$

$F_o$ étant la fréquence moyenne et Z1 et Z2 étant respectivement les résistances terminales des branches de sortie (A1, A2), un premier amplificateur (V1) et une seconde inductance (L') étant disposés dans la première branche de sortie (A1) en ligne respectivement après le premier condensateur (C) et après le premier amplificateur (V1), un second amplificateur (V2) et un second condensateur (C') étant disposés dans la seconde branche de sortie (A2) en ligne respectivement après la première inductance (L) et après le second amplificateur (V2), la seconde inductance (L') et le second condensateur (C') étant reliés entre eux sur une sortie.

Fig.1

$$C = \frac{1}{2\pi Z_1 F_0}$$

$$L = \frac{Z_2}{2\pi F_0}$$

Fig. 2